# EUROPÄISCHE PATENTSCHRIFT

(11) **EP 0 877 681 B1**
(45) Veröffentlichungstag und Bekanntmachung des Hinweises auf die Patenterteilung: **29.05.2002**
(21) Anmeldenummer: 97909189.9
(22) Anmeldetag: 25.09.1997
(51) Int. Cl.: B60R 16/02, H01R 9/24, H05K 5/00

(54) **VERBINDERANORDNUNG EINES STEUERUNGSSYSTEMS MIT EINEM STEUERGERÄT IN EINEM KRAFTFAHRZEUG**
CONNECTOR ARRANGEMENT FOR AN AUTOMOTIVE STEERING SYSTEM WITH A CONTROL UNIT
DISPOSITIF DE CONNECTEURS POUR SYSTEME DE DIRECTION AUTOMOBILE A UNITE DE COMMANDE

(30) Priorität: 06.12.1996 DE 29621257 U
(43) Veröffentlichungstag der Anmeldung: 18.11.1998
(73) Patentinhaber: ROBERT BOSCH GMBH, 70442 Stuttgart (DE)
(72) Erfinder: HOFMEISTER, Werner, D-75417 Mühlacker (DE); HERZOG, Achim, D-71522 Backnang (DE); SCHIEFER, Peter, D-74199 Untergruppenbach (DE); RAICA, Thomas, D-72379 Hechingen (DE); SCHOENFELD, Michael, D-70771 Leinfelden-Echterdingen (DE); SCHMID, Roland, D-72581 Dettingen (DE); BENTZ, Willy, D-74343 Sachsenheim (DE); SCHINZEL, Ralf, D-71726 Benningen (DE); STAAKE, Albert, D-71711 Murr (DE); LITZINGER, Rolf, D-72379 Hechingen (DE); SEITEL, Hans, D-73734 Esslingen (DE); EBERLEIN, Edwin, D-70197 Stuttgart (DE); SPENGLER, Eberhard, D-71706 Markgröningen (DE)
(86) Internationale Anmeldenummer: DE9702176
(87) Internationale Veröffentlichungsnummer: WO9824658

(56) Entgegenhaltungen:
- EP-A- 0 130 844
- DE-A- 4 117 179
- DE-A- 4 321 331
- DE-A- 19 518 136
- DE-U- 9 417 532
- US-A- 4 850 884
- US-A- 4 906 195

## Beschreibung

### Stand der Technik

Die Erfindung geht aus von einer Verbinderanordnung eines Steuerungssystems mit einem Steuergerät in einem Kraftfahrzeug nach der Gattung des Anspruchs 1.

Durch die DE 33 10 477 A1 ist als Teil eines Steuerungssystems in einem Kraftfahrzeug ein Steuergerät bekannt, das in Leiterplattentechnik aufgebaut ist. Üblicherweise ist ein solches Steuergerät im Fahrgastraum oder dem sogenannten Wasserkasten hinter der den Motorraum abschließenden Spritzwand des Kraftfahrzeuges untergebracht, um vor den rauhen Betriebsbedingungen im Motorraum des Kraftfahrzeuges geschützt zu sein.

Das Steuergerät weist eine in einer Öffnung eines Gehäuses des Steuergeräts gelagerte Steckerleiste als Gerätestecker auf, die eine Vielzahl von in Reihen gelagerten Kontaktelementen enthält. Die Kontaktelemente sind einerseits mit elektrischen Bauelementen auf der Leiterplatte des Steuergeräts verbunden und andererseits mit Gegenkontaktelementen eines sogenannten Kabelbaumsteckers verbindbar, über den sämtliche Ein- und Ausgangssignale des Steuergeräts geführt werden.

Von dem Kabelbaumstecker geht, anfangs gebündelt als Kabelbaum, eine Vielzahl von Kabeln ab, die zu, an einer Brennkraftmaschine des Kraftfahrzeugs angeordneten Sensoren und Stellelementen, aber auch, zumindest mittelbar, zu weiteren anderenorts in dem Kraftfahrzeug untergebrachten elektrischen Bauelementen führen, wie z.B. Leuchten in den Randbereichen des Kraftfahrzeugs oder zu Anzeigeinstrumenten im Armaturenbrett.

Um den Kabelbaum nicht unhandlich werden zu lassen, werden durch ihn üblicher Weise nur zusammenliegende Gruppen von Bauelementen direkt angeschlossen, während die Verbindung zu vereinzelt liegenden Bauelementen mittelbar über Zwischenstecker und angefügte Verlängerungskabel vorgenommen werden.

Des weiteren werden Kabel des Kabelbaums, über die hohe Ströme fließen, beispielsweise die Betriebsströme von Stellelementen, nicht über das Steuergerät geführt, sondern an den entsprechenden Kabeln werden sogenannte Splice-Stellen angebracht, an dem diese Kabel verzweigen. Die Verzweigungen sind in einem Trennstecker zusammengefaßt, von wo aus sie schließlich zu den zugeordneten Bauelementen führen.

Diese vorbeschriebene Ausbildung des Steuerungssystems mit einem solchermaßen ausgeführten Steuergerät und der entsprechenden Verbinderanordnung ist in nachteiliger Weise in der Herstellung und Montage kostenintensiv und durch die Verwendung von Zwischensteckern und dem Trennstecker infolge der zusätzlichen Kontaktstellen störungsanfällig. Des weiteren lassen sich Veränderungen in der Verbinderanordnung bei geänderen Einbaugegebenheiten der elektrischen Bauelemente des Kraftfahrzeugs nur mit großem Aufwand durchführen.

Aus der DE 195 18 136 A1 ist gattungsbildend eine Verbinderanordnung eines Steuerungssystems mit einem Steuergerät in einem Kraftfahrzeug bekannt. Das Steuergerät weist zwei Gerätestecker mit Kontaktelementen auf, an denen Gegenstecker mit Gegenkontaktelementen zur Bildung elektrischer Steckverbindungen reversibel ankoppelbar sind. Die Gegenstecker sind mit in dem Kraftfahrzeug angeordneten Geräten verbunden.

Einzelne der Kontaktelemente der Gerätestecker sind durch innerhalb des Steuergeräts verlaufende elektrische Verbindungen miteinander verbunden, so daß die über die Gegenstecker an die Gerätestecker angeschlossenen Geräte über die entsprechenden Anschlüsse direkt miteinander elektrisch verbunden sind.

Bei dem Steuergerät handelt es sich um ein ohnehin im Kraftfahrzeug vorhandenes Steuergerät für die Motorsteuerung des Kraftfahrzeugs. Solche Steuergeräte sind üblicherweise hinter der den Motorraum abschließenden Spritzwand des Kraftfahrzeugs untergebracht. Da diese Steuergeräte in herkömmlicher Leiterplattentechnik aufgebaut sind, sind sie großvolumig und insbesondere wegen ihrer Temperatur- und Schüttelempfindlichkeit nicht für den Direktanbau an einer Brennkraftmaschine des Kraftfahrzeugs geeignet.

Durch die von der Brennkraftmaschine beabstandete Anordnung des Steuergeräts in dem Kraftfahrzeug ergeben sich in unerwünschter Weise lange fertigungstechnisch aufwendig herzustellende Verbindungswege zwischen dem Steuergerät und den vielen, direkt an der Brennkraftmaschine angebrachten Geräten, insbesondere in Form von Stellgliedern für die Brennkraftmaschine.

Aufgabe der Erfindung ist es, die Verbindungsanordnung eines Steuerungssystems mit einem Steuergerät in einem Kraftfahrzeug in fertigungstechnisch günstiger Weise kostengünstig auszuführen.

### Vorteile der Erfindung

Die erfindungsgemäße Verbinderanordnung eines Steuerungssystems mit einem Steuergerät in einem Kraftfahrzeug mit den kennzeichnenden Merkmalen des Anspruchs 1 hat dem gegenüber den Vorteil, daß die zuvor erwähnten Unzulänglichkeiten in zufriedenstellendem Maße vermieden werden.

Insbesondere durch die Anbringung des Steuergerätes an der Brennkraftmaschine des Kraftfahrzeugs ist es möglich, eine Verbinderanordnung zu verwirklichen, die kurze Verbindungswege aufweist und Modifikationen auf Grund von unterschiedlichen Einbaugegebenheiten der elektrischen Bauelemente des Kraftfahrzeugs durch die Verwendung von Teilgegensteckern, die voneinander unabhängig handhabbar sind, zuläßt.

In den Unteransprüchen sind vorteilhafte Ausgestaltungen für die Realisierung der Erfindung angegeben.

### Zeichnung

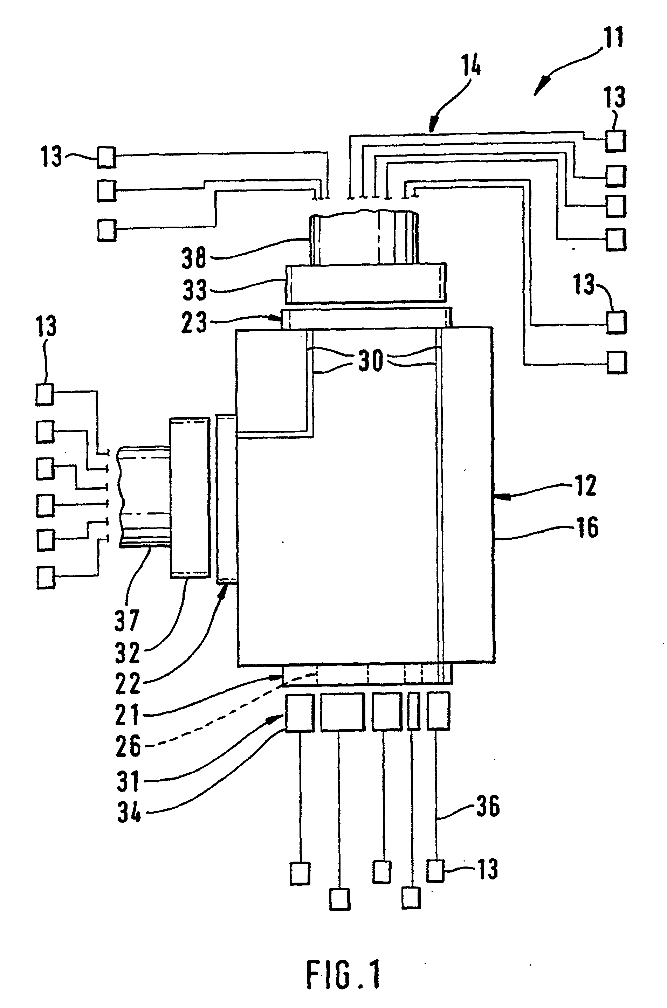

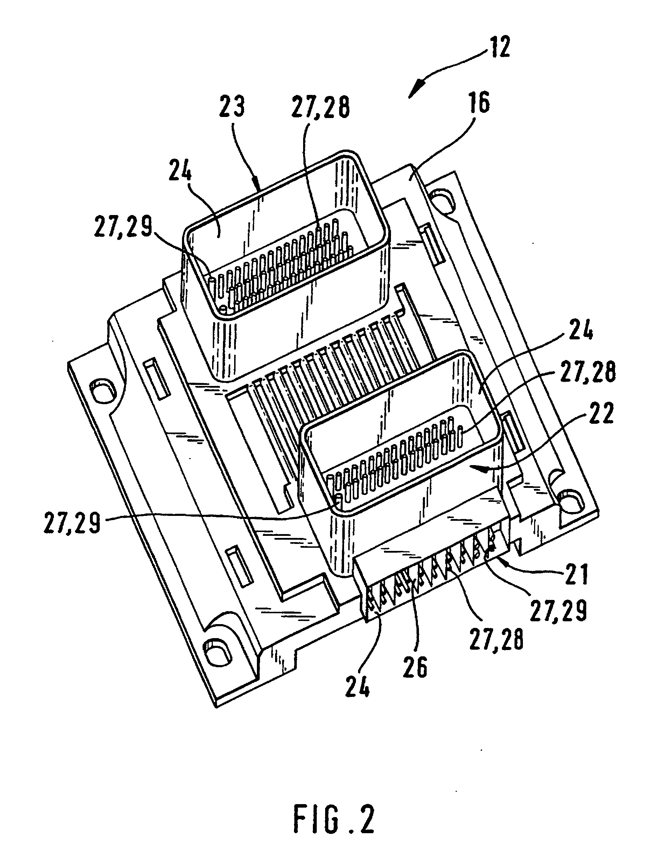

Ein Ausführungsbeispiel der Erfindung ist in der Zeichnung dargestellt und in der Figurenbeschreibung näher erläutert. Es zeigt die Figur 1 die Verbinderanordnung in einer Prinzipdarstellung und Figur 2 ein Steuergerät mit seinen Anschlußelementen für die Verbinderanordnung in einer räumlichen Darstellung.

### Beschreibung eines Ausführungsbeispiels

Ein Steuerungssystem 11 in einem Kraftfahrzeug nach Figur 1 umfaßt als wesentliche Bestandteile ein elektrisches Steuergerät 12, eine Vielzahl von elektrisch betriebenen Bauelementen 13 und eine Verbinderanordnung 14 zur elektrischen Verbindung der Bauelemente 13 mit dem Steuergerät 12.

Das Steuergerät 12, in der Figur 2 näher dargestellt, ist als ein Mikrohybrid-Steuergerät 12 ausgeführt. Diese Bauweise zeichnet sich dadurch aus, daß die in dem Steuergerät 12 enthaltenen Bauteile in miniaturisierter Form vorliegen, somit nur geringe Massen aufweisen und demzufolge bei Beschleunigungen nur kleine Massekräfte auftreten. Dadurch ist es möglich, das Steuergerät 12 als ein sogenanntes Anbau-Steuergerät 12 auszubilden, wobei es direkt auf einer Brennkraftmaschine des Kraftfahrzeugs montiert wird, da es auch gegen Temperaturschwankungen, Vibrationsbelastungen und Verschmutzungen hinreichend unempfindlich ist.

Das Steuergerät 12 weist ein Gehäuse 16 vorzugsweise aus Druckguß auf. An dem Gehäuse 16 ist ein erster Gerätestecker 21 als sogenannter Modularstecker, ein zweiter Gerätestecker 22 als sogenannter Motorstecker und ein dritter Gerätestecker 23 als sogenannter Karosseriestecker angebracht.

Die Gerätestecker 21-23 weisen jeweils einen außerhalb des Gehäuses 16 zugänglichen Aufnahmeraum 24 auf, der bei dem Gerätestecker 21 durch Wände 26 abschnittsweise unterteilt ist. In jedem Aufnahmeraum 24 ragen Kontaktabschnitte 27 von in Reihen angeordneten stiftförmigen Kontaktelementen 28, die elektrisch isolierend durch das Gehäuse 16 geführt sind und sich in nicht mehr dargestellter Weise im Innern des Gehäuses 16 mit Anschlußabschnitten fortsetzten, die zumindest mittelbar mit den zugeordneten Bauteilen des Steuergerätes 12 elektrisch leitend verbunden sind.

Die Kontaktelemente 28 sind in ihrer Querschnittsfläche auf niedrige Signalströme ausgelegt. Einige der Kontaktelemente 28 weisen jedoch eine vergrößerte Querschnittsfläche auf und sind als sogenannte Hochstromkontaktelemente 29 auf die Übertragung von, bezogen auf die Signalströme, höheren Strömen, wie beispielsweise Versorgungsströme von Stellelementen oder Lampen ausgelegt.

Die einander zugeordneten Hochstromkontaktelemente 29 der Gerätestecker 21-23 sind innerhalb des Steuergeräts 12 direkt, in der Regel ohne das Zwischenschalten von Bauteilen des Steuergeräts 12 durchgeschleift, wobei diese Direktverbindungen jeweils über eine Stromschiene 30 erfolgt, die in fertigungstechnisch günstiger Weise aus einem Stanzgitter als massive Metallbrücke hergestellt ist.

Mit dem ersten Gerätestecker 21 ist ein erster Gegenstecker 31, mit dem zweiten Gerätestecker 22 ein zweiter Gegenstecker 32 und mit dem dritten Gerätestecker 23 ein dritter Gegenstecker 33 koppelbar. Die Anzahl der Gerätestecker 21-23 und der Gegenstecker 31-33 kann alternativ auch davon abweichen und beispielsweise jeweils nur zwei betragen.

Der erste Gegenstecker 31 setzt sich aus mehreren Teilgegensteckern 34 zusammen, die unabhängig voneinander handhabbar sind und an die jeweils ein Ende eines Kabelschwanzes 36 angeschlossen ist. Das andere Ende des Kabelschwanzes 36 tritt aus einem der Bauelemente 13 aus und bildet mit diesem eine bauliche Einheit. Die Teilgegenstecker 34 kommen insbesondere zum Einsatz bei Bauelementen 13, die ebenfalls wie das Steuergerät 12 an der Brennkraftmaschine des Kraftfahrzeugs und somit in räumlicher Nähe zum Steuergerät 12 angebaut sind. Solche Bauelemente 13 sind beispielsweise ein Stellglied für eine Saugrohrumschaltung, ein Klopfsensor oder ein Temperaturfühler für das Kühlwasser der Brennkraftmaschine.

Der zweite Gegenstecker 32 und der dritte Gegenstecker 33 sind jeweils einteilig ausgebildet. An dem zweiten Gegenstecker 32 ist das eine Ende eines ersten Kabelbaumes 37 angeschlossen, dessen anderes Ende verzweigt ist. Diese Verzweigungen führen insbesondere zu Bauelementen 13, die noch mit der Brennkraftmaschine in Verbindung stehen, beispielsweise das Stellglied für eine Nockenwellenverstellung oder die Lambdasonde als Sensor.

In vergleichbarer Anordnung ist an dem dritten Gegenstecker 33 das eine Ende eines zweiten Kabelbaums 38 angeschlossen, dessen Verzweigungen am anderen Ende zu Bauelementen 13 führen, die insbesondere an der Karosserie des Kraftfahrzeugs angeordnet sind, wie beispielsweise ein Füllstandsensor eines Tanks oder Anzeigeinstrumente des Armaturenbretts.

Die vorstehend beschriebene Verbinderanordnung 14 in Verbindung mit einem solchermaßen aufgebauten Steuergerät 12 stellt eine fertigungstechnisch günstige Ausbildung des Steuerungssystems 11 dar, weil die Verbinderanordnung 14 übersichtlich ist, die an den Teilgegensteckern 34 angeschlossenen Bauelemente 13 unabhängig voneinander ausgetauscht werden können, dadurch eine Anpassung an unterschiedliche Belegungen mit Bauelementen 13 aufgrund von Kundenanforderungen unter Beibehaltung eines normierten Steuergeräts 12 besteht und eine hohe Betriebssicherheit des Steuerungssystems 11 durch die Minimierung der Kontaktstellen infolge des Wegfalls der Zwischenstecker und des Trennsteckers sowie der Splice-Stellen erreicht ist.

## Patentansprüche

1. Verbinderanordnung eines Steuerungssystems mit einem Steuergerät in einem Kraftfahrzeug, welches Steuergerät (12) mindestens einen außenseitig angebrachten Gerätestecker (21-23) mit Kontaktelementen (28) aufweist, an dem wenigstens ein Gegenstecker (31-33) mit Gegenkontaktelementen zur Bildung einer elektrischen Steckverbindung reversibel ankoppelbar ist, und wenigstens mit einem weiteren Gerätestecker (22, 23) des Steuergeräts (12) ein mit einem Kabelbaum (37, 38) verbundener weiterer Gegenstecker (32, 33) koppelbar ist, welcher Kabelbaum (37, 38) zumindest überwiegend mit elektrischen Bauelementen (13) des Kraftfahrzeugs elektrisch leitend verbunden ist, und einzelne der Kontaktelemente (28) der Gerätestecker (21-23) durch zwischen den Gerätesteckern (21-23) verlaufenden elektrischen Verbindungen in dem Steuergerät miteinander verbunden sind, **dadurch gekennzeichnet, daß** das Steuergerät (12) als ein Mikrohybrid-Steuergerät ausgeführt und an einer Brennkraftmaschine des Kraftfahrzeugs angebaut ist, einzelne der zwischen den Gerätesteckern (21-23) verlaufenden elektrischen Verbindungen als Stromschienen (30) ausgeführt sind, an einem ersten Gerätestecker (21) zumindest teilweise mit Kabelschwänzen (36) verbundene Teilgegenstecker (34) anschließbar sind, die Teilgegenstecker als voneinander unabhängig handhabbare Steckverbinder ausgebildet sind und die Kabelschwänze (36) zumindest überwiegend mit elektrischen Bauelementen (13) elektrisch leitend verbunden sind.

2. Verbinderanordnung nach Anspruch 1, **dadurch gekennzeichnet, daß** die Stromschienen (30) innerhalb eines Gehäuses (16) des Steuergeräts (12) verlaufen und endseitig mit Hochstromkontaktelementen (29) verbunden sind, die gegenüber den anderen Kontaktelementen (28) eine vergrößerte Querschnittsfläche aufweisen.

3. Verbinderanordnung nach Anspruch 2, **dadurch gekennzeichnet, daß** an einem Ende der Kabelschwänze (36) die Teilgegenstecker (34) angeschlossen sind und die anderen Enden der Kabelschwänze (36) jeweils an die zugeordneten Bauelemente (13) direkt angeschlagen sind und mit diesen eine bauliche Einheit bilden.

## Claims

1. Connector arrangement of a control system with a control unit in a motor vehicle, which control unit (12) has at least one unit plug (21-23) which is provided on the outside and has contact elements (28) to which at least one mating plug (31-33) with mating contact elements can be coupled in a reversible fashion in order to form an electrical plug connection, and a further mating plug (32, 33) which is connected to a cable harness (37, 38) can be coupled at least to one further unit plug (22, 23) which, cable harness (37, 38) is electrically conductively connected at least predominantly to electrical elements (13) of the motor vehicle, and some of the contact elements (28) of the unit plugs (21-23) are connected to one another by means of electrical connections in the control unit which run between the unit plugs (21-23), **characterized in that** the control unit (12) is embodied as a microhybrid control unit and is built onto an internal combustion engine of the motor vehicle, some of the electrical connections running between the unit plugs (21-23) are embodied as busbars (30), component mating plugs (34), at least some of which are connected to cable lengths (36), can be connected to a first unit plug (21), the component mating plugs are embodied as plug-type connectors which can be handled independently of one another and the cable lengths (36) are electrically conductively connected at least predominantly to electrical elements (13).

2. Connector arrangement according to Claim 1, **characterized in that** the busbars (30) run within a housing (16) of the control unit (12) and are connected at the end to high-current contact elements (29) which have an enlarged cross-sectional area in comparison with the other contact elements (28).

3. Connector arrangement according to Claim 2, **characterized in that** the component mating plugs (34) are connected up to one end of the cable lengths (36) and the other ends of the cable lengths (36) are each directly joined on to the associated elements (13) and form one structural unit with them.

## Revendications

1. Dispositif de connecteurs d'un système de commande comportant un appareil de commande dans un véhicule automobile, dans lequel
- l'appareil de commande (12) présente au moins un connecteur d'appareil (21-23) monté vers l'extérieur, comportant des éléments de contact (28) et auquel peut être accouplé de manière réversible au moins un contre-connecteur (31 à 33) équipé de contre-éléments de contact de manière à établir une liaison électrique enfichable,
- au moins un autre connecteur (22, 23) de l'appareil de commande (12) peut être accouplé à un autre contre-connecteurs (32, 33) relié à un faisceau de câbles (37, 38) qui au moins en grande partie est relié électriquement à des composants électriques (13) du véhicule, certains des éléments de contact (28) des connecteurs (21-23) étant reliés entre eux par des liaisons électriques situées à l'intérieur de l'appareil entre les connecteurs (21-23),
**caractérisé en ce que**
- l'appareil de commande (12) est du type micro-hybride et il est monté sur le moteur du véhicule automobile,
- certaines des liaisons électriques entre les connecteurs (21-23) sont constituées par des rails de courant (30),
- à un premier connecteur (21) peut être raccordé au moins en partie des contre-connecteurs élémentaires (34) reliés au moins en partie à des faisceaux de câbles (36),
- les contre-connecteurs élémentaires sont constitués par des connecteurs manipulables indépendamment les uns des autres, et
- les faisceaux de câbles (36) sont au moins pour la plus grande part reliés électriquement à des composants électriques (13).

2. Dispositif des connecteurs selon la revendication 1,
**caractérisé en ce que**
les rails de courant (30) se trouvent à l'intérieur du boîtier (16) de l'appareil de commande (12), et leurs extrémités sont reliées à des éléments de contact à intensité élevée (29) présentant une section plus importante que celle des autres éléments de contact (28).

3. Dispositif de connecteurs selon la revendication 2,
**caractérisé en ce qu'**
à une extrémité des faisceaux de câbles (36) sont raccordés les contre-connecteurs élémentaires (34), tandis que les autres extrémités des faisceaux de câbles (36) aboutissent directement chacune au composant associé (13) et forment une unité avec celui-ci.
